# EUROPEAN PATENT SPECIFICATION

(11) **EP 3 899 380 B1**
(45) Date of publication and mention of the grant of the patent: **16.07.2025**
(21) Application number: 19898367.8
(22) Date of filing: 20.12.2019
(51) Int. Cl.: F25B 9/00, F24F 3/06, F25D 3/08, F28F 27/00, F24F 11/62, H05K 7/20, F28D 5/00, F24F 1/039, F24F 5/00, F24F 11/65

(54) **EVAPORATIVE COOLER WET AND DRY MODE CONTROL**
NASS- UND TROCKENMODUSREGELUNG FÜR VERDUNSTUNGSKÜHLER
COMMANDE DE MODE HUMIDE ET SEC DE REFROIDISSEUR À ÉVAPORATION

(30) Priority: 20.12.2018 US 201862782944 P
(43) Date of publication of application: 27.10.2021
(73) Proprietor: Nortek Air Solutions Canada, Inc., Saskatoon, Saskatchewan S7K 1V7 (CA)
(72) Inventor: VAN DEN HURK, Marcel, Quebec Avenue Saskatoon, Saskatchewan S7K 1V7 (CA); ABDEL-SALAM, Ahmed Hamdi, Saskatoon, Saskatchewan S7N 3Z1 (CA); REGIER, Christopher, Saskatoon, Saskatchewan S7J 3Z1 (CA); LEPOUDRE, Philip Paul, Saskatoon, Saskatchewan S7H 4A4 (CA)
(74) Representative: Marks & Clerk LLP
(86) International application number: PCT/CA2019/051883
(87) International publication number: WO 2020/124261

(56) References cited:
- EP-A2- 1 035 397
- WO-A1-2017/160346
- WO-A1-2018/191806
- WO-A1-2019/046956
- WO-A1-2019/095070
- WO-A2-2014/030083
- US-A1- 2018 073 753

## Description

### BACKGROUND

Evaporative coolers are systems commonly used in various heating ventilation and air conditioning (HVAC) applications. Evaporative coolers receive a process fluid from a source, such as a building or nearby HVAC equipment, cool the process fluid, and return the process fluid to the source or other equipment. Evaporative coolers use sensible and latent (or evaporative) cooling to cool the process fluid in a normal mode of operation (wet mode). Some evaporative coolers, such as hybrid evaporative coolers, are able to cool the process fluid in a second mode, such as a dry mode. In a dry mode, evaporative coolers can use only sensible cooling through forced conduction to cool the process fluid. EP1035397A2 discloses a low profile heat exchange system and method with reduced water consumption.

### SUMMARY

In accordance with the invention, there is provided: a hybrid evaporative cooler system as recited by claim 1; and a method of controlling a hybrid evaporative cooler system as recited by claim 10.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 illustrates a schematic view of a system, in accordance with at least one example of this disclosure, disclosure meaning herein "disclosure of the invention".
FIG. 2 illustrates a schematic view of a system, in accordance with at least one example of this disclosure.
FIG. 3 illustrates a schematic view of a system, in accordance with at least one example of this disclosure.
FIG. 4 illustrates a schematic view of a system, in accordance with at least one example of this disclosure.
FIG. 5 illustrates a schematic view of a method of operating a system, in accordance with at least one example of this disclosure.

### DETAILED DESCRIPTION

Some evaporative coolers, such as hybrid evaporative coolers, are able to cool process fluid in either a dry mode or a wet mode. A controller can be used to determine when to switch modes. Switching from dry mode to wet mode can be relatively simple. During operation of an evaporative cooler in dry mode, the fan speed will eventually reach a maximum speed as outdoor air temperature increases. When the supply process water temperature is not met (when the supply process water temperature is above the set point) and the maximum fan speed is reached, a maximum available sensible cooling is reached and the wet mode can be enabled to further cool the process water or other fluid to meet the set point.

However, optimally switching from wet mode to dry mode can be relatively more difficult. This is in part because many variables affect the performance of the evaporative cooler such as the ambient dry bulb and wet bulb temperatures, the entering water temperature, the condition of the cooling coil, the flowrate and/or other properties of the working water. Two approaches are discussed below that are used in the HVAC industry to control the switching from wet to dry mode in hybrid evaporative cooling units.

A first approach uses a fixed outdoor air dry bulb temperature as a set point to switch from wet mode to dry mode. When the outdoor air dry bulb temperature is below the set point, a controller disables the working fluid or recirculation pump to operate the cooler in the dry mode. A second approach uses a fan speed signal to control switching to dry mode. When the fan reaches its minimum speed in wet mode, the controller can change to dry mode. A drawback of these approaches is that in both cases the evaporative cooler may continue operating under wet mode for more time than is actually required, which can cause more water to be used in wet mode than is required.

This disclosure provides a control method and a hybrid evaporative cooler system according to the claims that determines when to switch from wet to dry mode. The hybrid evaporative cooler system includes a controller configured to determine a minimum water temperature that can be produced by the evaporative cooler in dry mode while the evaporative cooler is still in wet mode. The controller determines the minimum process water temperature that can be produced by the cooling coil using a model of the coil of the evaporative cooler. The model may be a theoretical model or an empirical model. In some examples, the controller can use inputs from sensors of the evaporative cooler to determine the minimum water temperature with the model. The inputs can be, for example, process water inlet and outlet temperatures, a process water flow rate, an air inlet temperature, and an air outlet temperature.

Such a system and control method can increase the water efficiency of evaporative coolers, increase the lifetime of wet media, and other mechanical equipment associated with them (e.g. pumps, filters, strainers), decrease water treatment requirements due to the associated reduction in water usage, increase shutdown time for wet media and all mechanical equipment associated with them, which enables more accessibility to conduct preventative and corrective maintenance, and can reduce the total cost of ownership for hybrid evaporative coolers.

In some examples, the system control can be adjusted to account for heat exchanger degradation over time, such as due to scaling, to help ensure that the change from wet to dry mode occurs at an optimal outdoor air temperature through a life of the equipment.

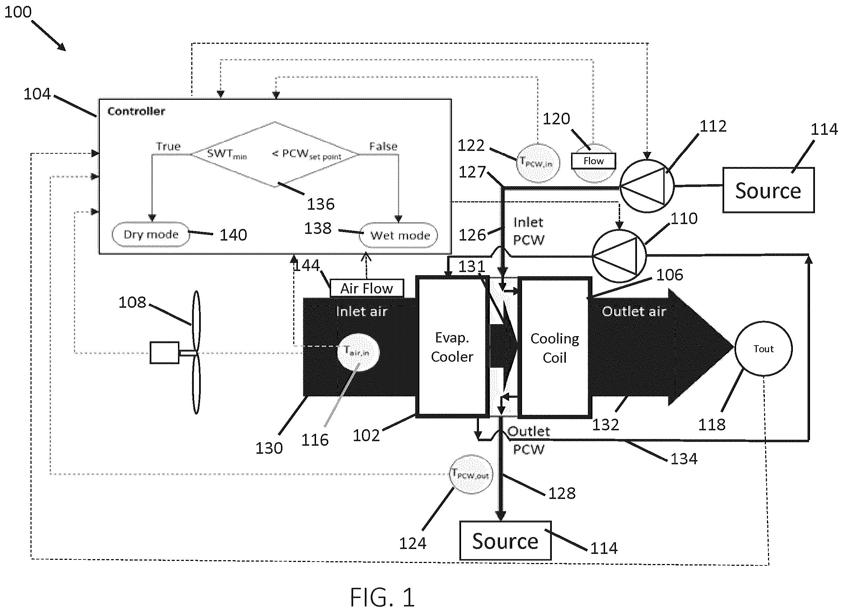

FIG. 1 illustrates a schematic view of an evaporative cooler system, in accordance with at least one example of this disclosure. The system 100 includes an evaporative cooler 102, a controller 104, a cooling coil 106, and a fan 108. The system 100 can further include a recirculation pump 110, a process fluid pump 112, a process fluid source 114, an inlet air temperature sensor 116, an outlet air temperature sensor 118, a process fluid flow sensor 120, a process fluid inlet temperature sensor 122, and a process fluid outlet temperature sensor 124. Also shown in FIG. 1 is process inlet fluid 126, process fluid 127, process outlet fluid 128, inlet air 130, conditioned air 131, outlet air 132, working fluid (recirculated fluid) 134, and an air flow sensor 144.

The evaporative cooler 102 can be an evaporative cooler configured to cool process fluid using one or more of working air and working water or fluid. The evaporative cooler 102 can be a hybrid evaporative cooler located upstream of the cooling coil 106, such as in examples that includes a wet media. The wet media of the evaporative cooler 102 can be of any design such as a membrane air-to-liquid exchanger, falling film exchanger, packed media exchanger, or other wet media design that cools the air stream using evaporative cooling. In some examples, the evaporative cooler 102 and the cooling coil 106 can be combined in a single heat exchanger.

In some examples, the evaporative cooler 102 can be a liquid to air membrane energy exchanger (LAMEE) to transfer heat and moisture between a liquid desiccant and an air stream to condition the temperature and humidity of the air flowing through the LAMEE. The membrane in the LAMEE can be a non-porous film having selective permeability for water, but not for other constituents that form the liquid desiccant. Many different types of liquid desiccants can be used in combination with the non-porous membrane, including, for example, glycols. The non-porous membrane can make it feasible to use desiccants, such as glycols, that had been previously determined to be unacceptable or undesirable in these types of applications. In an example, the membrane in the LAMEE can be semi-permeable or vapor permeable, and generally anything in a gas phase can pass through the membrane and generally anything in a liquid phase cannot pass through the membrane. In an example, the membrane in the LAMEE can be micro-porous such that one or more gases can pass through the membrane. In an example, the membrane can be a selectively-permeable membrane such that some constituents, but not others, can pass through the membrane. It is recognized that the LAMEEs included in the conditioning units disclosed herein can use any type of membrane suitable for use with an evaporative cooler LAMEE.

In an example, the LAMEE or exchanger can use a flexible polymer membrane, which is vapor permeable, to separate air and water. The water flow rate through the LAMEE may not be limited by concerns of carryover of water droplets in the air stream, compared to other conditioning systems. The LAMEE can operate with water entering the LAMEE at high temperatures and high flow rates, and can therefore be used to reject large amounts of heat from the water flow using latent heat release (evaporation).

The cooling fluid circulating through the LAMEE or exchanger can include water, liquid desiccant, glycol, other hygroscopic fluids, other evaporative liquids, and/or combinations thereof. In an example, the cooling fluid is a liquid desiccant that is a low concentration salt solution. The presence of salt can sanitize the cooling fluid to prevent microbial growth. In addition, the desiccant salt can affect the vapor pressure of the solution and allow the cooling fluid to either release or absorb moisture from the air. The concentration of the liquid desiccant can be adjusted for control purposes to control the amount of cooling of the scavenger air or cooling fluid within the LAMEE or exchanger.

Membrane exchangers may have some advantages over other types of evaporative coolers. For example, the LAMEE may eliminate or mitigate maintenance requirements and concerns of conventional cooling towers or other systems including direct-contact evaporation devices, where the water is in direct contact with the air stream that is saturated by the evaporated water. For example, the membrane barriers of the LAMEE inhibit or prohibit the transfer of contaminants and micro-organisms between the air and the liquid stream, as well as inhibiting or prohibiting the transfer of solids between the water and air. The use of LAMEEs along with an upstream or downstream cooling coil can result in a lower temperature of the water leaving the LAMEE and a higher cooling potential. Various configurations of cooling systems having a LAMEE can boost performance in many climates. Higher cooling potential and performance can result in lower air flow and fan power consumption in the cooling system, which is the main source of energy consumption in liquid-cooling systems. In an example in which the heat load is from a data center, this can increase the overall data center cooling system efficiency.

The cooling coil 106 can be a heat exchanger configured to exchange heat between the process fluid (127), the air (130, 131, 132), and the working fluid 134. In some examples, the cooling coil 106 can include tubes and/or fins for transfer of heat between the fluids and can include an evaporative media configured to receive the working fluid 134 thereon and to evaporate the working fluid 134 into the air (130, 132) to transfer heat from the process fluid (126, 128) to the air (130, 132) through latent heat of vaporization of the working fluid 134.

The controller 104 can be a programmable controller, such as a single or multi-board computer, a direct digital controller (DDC), or a programmable logic controller (PLC). In other examples the controller 104 can be any computing device, such as a handheld computer, for example, a smart phone, a tablet, a laptop, a desktop computer, or any other computing device including a processor and wireless or wired communication capabilities. Though the connections to the controller are shown as being a single direction, communication can occur in both directions between the controller 104 and components connected thereto. The various components can be connected via wire, optical cable, and/or wirelessly. Though the controller 104 is discussed as being an electronic controller, the controller 104 can be other types of controllers, such as a pneumatic controller.

The fan 108 can be one or more fans or pumps configured to motivate air to flow. The fan 108 can be an axial, centrifugal (plug), or the like. The fan 108 is located in or connected to an air tunnel or chamber either upstream or downstream of the cooling coil 106.

The recirculation pump 110 can be a fluid pump (such as a water or glycol pump) configured to pump fluid to the evaporative cooler 102 for wetting of the evaporative media of the evaporative cooler 102. In some examples, the pump 110 can be connected to a basin, drain pan, tank, or sump where run-off from the coil can be collected. In some examples, the evaporative cooler 106 can receive fluid from a tank in a gravity-fed arrangement. In some examples, the recirculation pump 110 can be a positive displacement or rotary pump, such as a centrifugal pump configured to pump fluid to a top portion of evaporative cooler 102 for distribution across and down the evaporative cooler 102. In other examples, the fluid can be pumped to other portions of the evaporative cooler 102 for distribution. In some examples, the recirculation pump 110 can be electrically connected to the controller 104 such that the controller can control operation of the recirculation pump 110, such as whether the recirculation pump 110 is on or off and at what speed the recirculation pump 110 operates.

Similarly, the process fluid pump 112 can be a fluid pump (such as a water or glycol pump) configured to pump the process fluid 127 from the source 114 to the cooling coil 106 and back to the source. The circuit including the source 114, the cooling coil 106, and the process fluid pump 112 can include various other components, such as valves, strainers, air separators, expansion tanks, other heat exchanges, or the like. The process fluid pump 112 can be a positive displacement or rotary pump, such as a centrifugal pump configured to pump water through the process fluid circuit. In some examples, the process fluid pump 112 can be electrically connected to the controller 104 such that the controller can control operation of the process fluid pump 112, such as whether the process fluid pump 112 is on or off and at what speed the process fluid pump 112 operates.

The process fluid source 114 can be a piece of equipment configured to use the process fluid 127. For example, the process fluid source 114 can be a cooling coil of an air tunnel, computer room air conditioning (CRAC) unit, chilled beam, fan coil, or the like. The process fluid source 114 can receive chilled or cooled fluid from the process fluid outlet 128, transfer heat to the process fluid 127 and discharge the process fluid 127 to the process fluid pump 112.

The inlet air temperature sensor 116 can be located in the inlet air stream 130 and can be configured to produce an inlet temperature signal based on a dry bulb and/or a wet bulb temperature of the inlet air stream 130. In some examples, the air temperature sensor 116 can measure (or can effectively measure) an ambient air temperature. The inlet air temperature sensor 116 can be electrically connected to controller 104 and configured to transmit the inlet temperature signal thereto. Each of the inlet air temperature sensor 116 and the outlet air temperature sensor 118 can be any type of temperature sensor, such as a thermistor, thermocouple, resistance temperature detector, a wetted wick, a chilled mirror sensor, a capacitive humidity sensor, a resistive humidity sensor, or the like.

Similarly, the outlet air temperature sensor 118 can be located in the outlet air stream 132 and can be configured to produce an outlet temperature signal based on a dry bulb and/or a wet bulb temperature of the outlet air stream 132. The outlet air temperature sensor 118 can be electrically connected to controller 104 and configured to transmit the outlet temperature signal thereto.

The process fluid flow sensor 120 can be connected to the process fluid circuit, such as upstream of the cooling coil 106 near the process fluid inlet 126. The process fluid flow sensor 120 can be any type of flow or pressure sensor, such as a differential pressure sensor, a Coriolis sensor, a paddle sensor, a paddle wheel sensor, or the like. The process fluid flow sensor 120 can be configured to produce a flow signal based on a flow rate of the process fluid 127 through the cooling coil 106. The process fluid flow sensor 120 can be connected to the controller 104 to transmit the process fluid flow signal thereto.

The process fluid inlet temperature sensor 122 can be connected to the process fluid circuit, such as upstream of the cooling coil 106 in the process fluid inlet 126. The process fluid inlet temperature sensor 122 can be configured to produce a process fluid inlet temperature signal based on a temperature of the process fluid 127 at the process fluid inlet 126 to the cooling coil 106. The process fluid inlet temperature sensor 122 can be connected to the controller 104 to transmit the process fluid inlet temperature signals thereto. The process fluid inlet temperature sensor 122 and the process fluid outlet temperature sensor 124 can be any type of fluid temperature sensor, either in a thermowell, coupled to a pipe of the process fluid circuit, or in direct contact with the process fluid, such as a thermistor, thermocouple, resistance temperature detector, or the like.

The process fluid outlet temperature sensor 124 can be connected to the process fluid circuit, such as downstream of the cooling coil 106 in the process fluid outlet 128. The process fluid outlet temperature sensor 124 can be configured to produce a process fluid outlet temperature signal based on a temperature of the process fluid 127 at the process fluid outlet 128 of the cooling coil 106. The process fluid outlet temperature sensor 124 can be connected to the controller 104 to transmit the process fluid outlet temperature signal thereto.

In operation of the evaporative cooler in a first wet mode, which can be referred to as an adiabatic mode, the process fluid pump 112 can be on and pumping fluid through the cooling coil 106 in a cooling coil closed circuit. The recirculation pump 110 can be on and pumping fluid to evaporative media of the evaporative cooler 102 in an evaporative cooler closed circuit. The fan 108 can be on and delivering an air stream to the evaporative cooler 102, which can follow to the cooling coil 106. The working fluid 134 can be evaporated into the inlet air 130 to condition the inlet air 130 adiabatically to create conditioned air 131. The conditioned air 131 can have a reduced dry-bulb temperature with a higher humidity level, while the overall enthalpy can remain constant where the conditioned air 131 can have a larger sensible cooling capacity than the inlet air 130.

The conditioned air 131 can be delivered to the cooling coil 106 where the conditioned air 131 can receive heat from the process fluid 127 to cool the process fluid 127 via the cooling coil 106 to provide the process fluid 127 at the process fluid outlet 128 with a temperature at the process fluid set point or target. When the controller 104 determines that the evaporative cooler 102 can be switched from wet mode to dry mode, the controller can send signals to disable the recirculation pump 110 and can adjust a speed of the fan 108, as necessary, to maintain the process fluid set point or target.

As shown within the controller 104, the controller 104 performs a step 136 to determine whether the minimum supply water temperature (SWTmin) is less than the process fluid set point (PCW set point), where the SWTmin is the lowest temperature of process fluid that the cooling coil 106 can deliver at a given ambient temperature or a given inlet air temperature while operating in the dry mode. Such a calculation can be performed when a maximum air flow rate that can be received by the cooling coil 106 is known. The "process fluid set point" or "Process Conditioned Water (PCW) set point" is also referred to herein as the "leaving process fluid temperature set point." This temperature set point is the target or desired temperature of the fluid leaving (e.g., at the fluid outlet of) the cooling coil 106. The inlet air temperature can be delivered to the controller via the inlet air temperature sensor 116, as discussed above. In examples, where ambient temperature is used to calculate SWTmin, an additional outdoor or ambient temperature sensor can be used.

When it is true that the SWTmin is less than the process fluid temperature set point, the controller enables dry mode at step 140 (in one example by locking out or disabling the evaporative cooler 102), because the controller 104 has determined that dry mode should provide the required process water temperature at the set point. When it is not true that the SWTmin is less than the process fluid set point, the controller 104 maintains wet mode at step 138. By including an ability to use a dry mode whenever possible, the system 100 can help to minimize the fluid usage, helping to save water. The determination of when to switch to dry mode by the controller 104 is discussed in further detail below.

**In** some examples, the controller 104 can calculate the SWTmin when the system 100 is operating in the dry mode (or when the evaporative cooler 102 is not enabled) and when it is not true that the SWTmin is less than the process fluid set point, the controller 104 can maintain dry mode at step 138 when the process fluid outlet temperature signal from the temperature sensor 124 indicates that the temperature of the process fluid 127 at the process fluid outlet 128 of the cooling coil 106 is actually equal or below the PCW set point. In such a circumstance, the controller 104 can update the theoretical model for determining the SWTmin.

In some examples, the controller 104 can include a theoretical model to predict the SWTmin that can be achieved by the system 100 in dry mode for an ambient (outdoor) or inlet air temperature under any available operating condition. For example, the controller 104 can predict the SWTmin at a maximum speed of the fan 108 and/or at a minimum or maximum air flow rate. In some examples, the controller 104 can predict the SWTmin at any flow rate measured by the air flow sensor 144. The theoretical model can be a computational model using heat transfer and fluid mechanics equations to determine performance of the cooling coil 106 at certain conditions.

The controller 104 can additionally or alternatively include an empirical model. Such a model can be a performance model of the cooling coil 106 developed based on measurements taken in a lab and/or during operation of the cooling coil 106 or a similar cooling coil of another system. In some examples, the empirical model can be updated during operation of the cooling coil 106 in dry mode.

The controller 104 can use the empirical model and/or the theoretical model and one or more inputs to determine the SWTmin. For example, the controller 104 can use data from the process fluid inlet temperature signal, the process water outlet temperature signal, the inlet air temperature signal, the outlet air temperature signal, an air flow rate signal (discussed below) and/or the process water flow signal input the data into the theoretical model and/or the empirical model and output the SWTmin. Once the controller 104 has calculated the SWTmin, the controller 104 can determine whether dry mode operation can provide process water with a leaving temperature that meets the set point or target temperature.

The process water inlet temperature signal can be received at the controller 104 from the process water inlet temperature sensor 122; the process water outlet temperature signal can be received at the controller 104 from the process water outlet temperature sensor 124; the inlet air temperature signal can be received at the controller 104 from the inlet air temperature sensor 116; the outlet air temperature signal can be received at the controller 104 from the outlet air temperature sensor 118; and, the process water flow signal can be received at the controller 104 from the process water flow sensor 120.

In some examples, only the air side inputs (air temperatures) can be used to determine the SWTmin. In some examples, only the water side inputs (process fluid temperatures and/or flowrate) can be used to determine the SWTmin. In some examples, a combination of both air and process fluid signals can be used. In one example, the inlet air temperature signal, the inlet process fluid temperature signal, and/or the outlet process fluid temperature signal can be used with the theoretical model and/or the empirical model to determine the SWTmin.

In some examples where it is desired to use a controller requiring less computing power, a lookup table or a regression correlation can be created based on a theoretical model and/or an empirical model and the table or correlation can be included in the controller 104. The controller 104 can then use one or more inputs to lookup the SWTmin for making the determination of when to switch to dry mode.

Because thermal performance of the cooling coil 106 can change over time due to operational factors (e.g. fouling, corrosion), the actual performance of the cooling coil 106 can deviate from the theoretical and/or empirical model developed for a clean coil. To correct for performance degradation over the lifetime of the cooling coil 106, the thermal performance of the cooling coil 106 can be updated. The updates to the theoretical and/or empirical models can be done based on time and/or based on data saved from each of the signals, where the signals can be stored as data and can be used to measure thermal performance of the cooling coil 106 in various conditions. The data and thermal performance can be used to update lookup tables, and can be updated based on artificial neural networks and deep learning tools that account for the degradation in thermal performance of the cooling coil 106.

Further, the data can be collected from one or more of the sensors, such as the inlet air temperature sensor 116, the outlet air temperature sensor 118, the process fluid flow sensor 120, the process fluid inlet temperature sensor 122, and/or the process fluid outlet temperature sensor 124, and/or any other sensors discussed above or below. The data from the sensors can be used by artificial neural networks and/or deep learning tools to update the model used to determine the SWTmin.

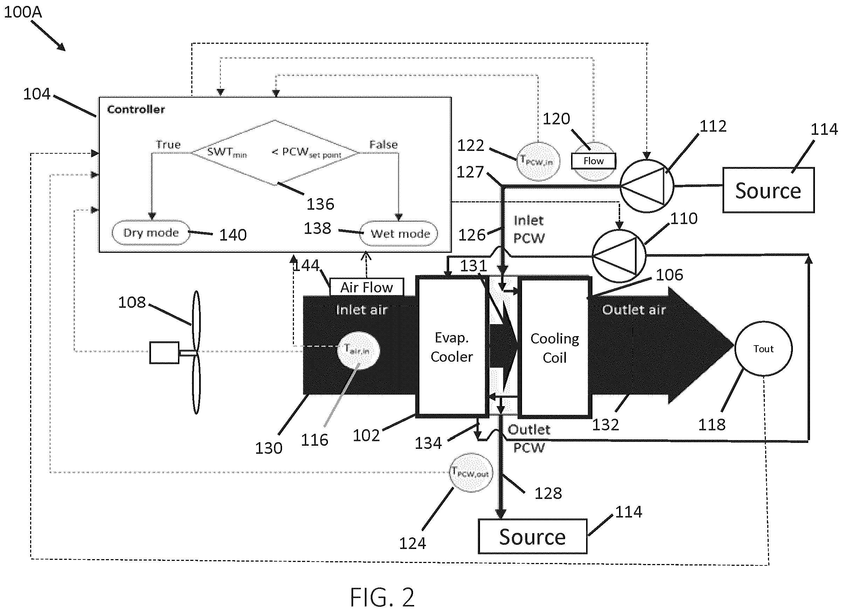

FIG. 2 illustrates a schematic view of an evaporative cooler system 100A, in accordance with at least one example of this disclosure. Any of the components of the system 100A can be included in the systems discussed above and below.

The system 100A includes an evaporative cooler 102, a controller 104, a cooling coil 106, and a fan 108. The system 100A can further include a recirculation pump 110, a process fluid pump 112, a process fluid source 114, an inlet air temperature sensor 116, an outlet air temperature sensor 118, a process fluid flow sensor 120, a process fluid inlet temperature sensor 122, and a process fluid outlet temperature sensor 124. Also shown in FIG. 2 is process inlet fluid 126, process fluid 127, process outlet fluid 128, inlet air 130, conditioned air 131, outlet air 132, working fluid (recirculated fluid) 134, and an air flow sensor 144.

The system 100A can be similar to the system 100 of FIG. 1, except that circuits of the working fluid 134 and the process fluid 127 can be connected (as opposed to adiabatic mode where the working fluid 134 and the process fluid 127 circuits can be isolated) for serial delivery of fluid from the cooling coils 106 to the evaporative cooler 102. In some examples, the system 100A can be the same as the system 100 where the changes in fluid flow are performed by valves in one or more fluid circuits.

In operation of the system 100A in a second wet mode, which can be referred to as an evaporative mode, the process fluid pump 112 can be on and pumping fluid through the cooling coil 106. The process fluid 127 can be cooled by the conditioned air 131 to create cooled process fluid 127. The cooled process fluid 127 can then be delivered to the evaporative cooler 102. The working fluid 134 (which can be the same as the process fluid 127) can be delivered to the evaporative cooler 102 to be passed over the evaporative cooler 102, such as media of the evaporative cooler 102, where a portion of the process fluid 127 can be evaporated into the inlet air 130 to cool the inlet air 130 to create the conditioned air 131 (as described above with respect to system 100) and the process fluid 127 can be cooled by the evaporative cooler. The process fluid 127 leaving the evaporative cooler 102 can be delivered to the process fluid outlet 128 to provide the process fluid 127 at a temperature meeting the process fluid set point or target so that the process fluid 127 can be then delivered to the source 114. In some examples of the evaporation wet mode, depending on operating condition, a portion of the fluid leaving the cooling coil 106 can be mixed with fluid leaving the evaporative cooler 102 for delivery to the source 114 at a temperature at the process fluid set point or target.

On the air side, the fan 108 can be on and delivering an air stream to the evaporative cooler 102 and the cooling cool 106. The working fluid 134 can cool the inlet air 130 to create the conditioned air 131, which can be delivered to the cooling coil 106 for cooling of the process fluid 127.

In the evaporative wet mode, when the controller 104 determines that the evaporative cooler 102 can be switched from wet mode to dry mode, the controller can send signals to the process fluid pump 112 and valves of the circuits to direct fluid flow through only the cooling coil 106 and can adjust a speed of the fan 108, as necessary, to maintain the process fluid set point or target. As shown within the controller 104, the controller 104 can perform a step 136 to determine whether the SWTmin is less than the PCW set point to determine when the switch to dry mode should be made, as discussed above with respect to FIG. 1.

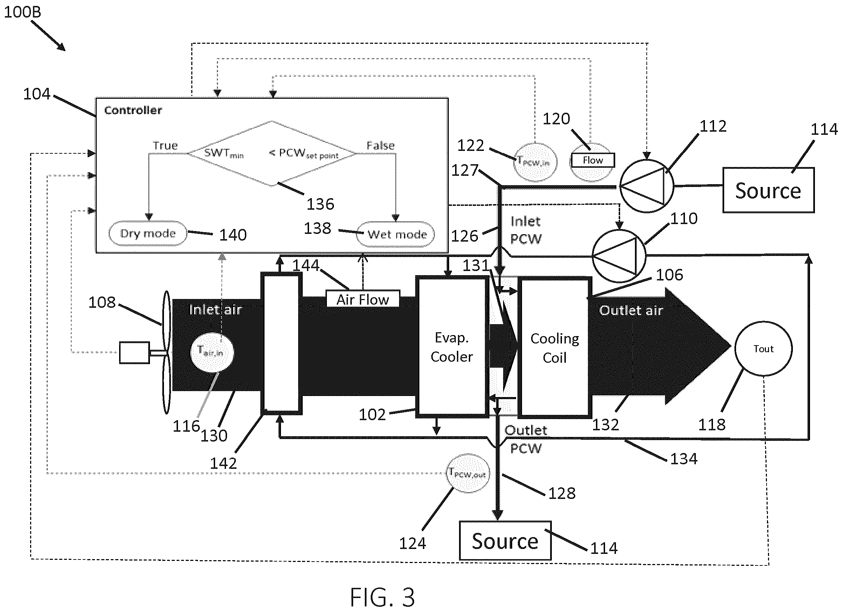

FIG. 3 illustrates a schematic view of an evaporative cooler system 100B, in accordance with at least one example of this disclosure. Any of the components of the system 100A can be included in the systems discussed above and below.

The system 100B includes an evaporative cooler 102, a controller 104, a cooling coil 106, and a fan 108. The system 100B can further include a recirculation pump 110, a process fluid pump 112, a process fluid source 114, an inlet air temperature sensor 116, an outlet air temperature sensor 118, a process fluid flow sensor 120, a process fluid inlet temperature sensor 122, and a process fluid outlet temperature sensor 124. Also shown in FIG. 3 are a process inlet fluid 126, process fluid 127, process outlet fluid 128, an inlet air 130, conditioned air 131, outlet air 132, working fluid (recirculated fluid) 134, a pre-cooling coil 142, and an air flow sensor 144.

The system 100B can be similar to the system 100 of FIG. 1, except that the system can include the pre-cooling coil 142. The pre-cooling coil 142 can be a heat exchanger configured to exchange heat between the fluid and air. In some examples, the pre-cooling coil 142 can include tubes and/or fins for transfer of heat between the fluids. The pre-cooling coil 142 can be configured to receive working fluid 134 (and/or process fluid) from the recirculation pump 110 (and/or from the process fluid pump 112) for passing through tubes of the pre-cooling coil 142 such that the working fluid 134 can receive heat sensibly from air delivered from the fan 108. The air can be conditioned (such as cooled) by the pre-cooling coil 142 and can be delivered as pre-cooled air to the evaporative cooler 102 to increase a total cooling capacity of the system 100B. In some examples, fluids other than the working fluid 134 can be delivered to the pre-cooling coil. In some examples, the working fluid 134 leaving the pre-cooling coil can be delivered to the evaporative cooler 102.

The system 100B can also include an air flow sensor 144, which can be a sensor configured to measure a volumetric (or mass) flow rate of air through the pre-cooling coil 142, the evaporative cooler 104, and the cooling coil 106. The fan flow sensor can be connected to the controller 102 and configured to deliver an air flow rate signal to the controller 102 based on a detected flow rate of the air stream (such as at the inlet air 130, the conditioned air 131, and/or the outlet air 132). In some examples, the air flow rate signal can be used by the controller 102 to determine the SWTmin. Though the air flow sensor 144 is shown as between the pre-cooling coil 142 and the evaporative cooler 102, the air flow sensor 144 can be positioned anywhere in the air stream (130, 131, 132). Though not discussed with respect to the systems 100 and 100A, either system can include the air flow sensor 144, as shown in FIGS. 1 and 2.

In operation of the evaporative cooler in a third wet mode, which can be referred to as a super-evaporative mode, the process fluid pump 112 can be on and pumping fluid through the cooling coil 106 where the process fluid 127 can be cooled by the conditioned air 131 to provide the process fluid 127 at the process fluid outlet 128 with a temperature at the process fluid set point or target where the process fluid 127 can be then delivered to the source 114.

In some examples, a portion of the process fluid from the cooling coil 106 can be delivered to the evaporative cooler 102 and can be evaporated into the inlet air stream 130 to create the conditioned air 131. In some examples, the recirculation pump 110 can provide all or some of the flow to the evaporative cooler 102. Some or all of the fluid leaving the evaporative cooler 102 can provide the process fluid 127 at the process fluid outlet 128 (mixed with fluid leaving the cooling coil 106 in some examples) with a temperature at the process fluid set point or target, where the process fluid 127 can be then delivered to the source 114. In other examples, some or all of the fluid leaving the evaporative cooler 102 can be delivered to the pre-cooling coil 142. The pre-cooling coil can use fluid from the evaporative cooler 102 and/or the recirculation pump 110 to pre-cool the inlet air 130. Fluid leaving the pre-cooling coil 142 can be delivered to the process fluid outlet 128 (and can be mixed with fluid leaving the cooling coil 106 and/or the evaporative cooler 102 in some examples) with a temperature at the process fluid set point or target, where the process fluid 127 can be then delivered to the source 114. On the air side, the fan 108 can be on and delivering an air stream to the pre-cooling coil 142, the evaporative cooler 102, and then to the cooling cool 106.

When the controller 104 determines that the evaporative cooler 102 can be switched from wet mode to dry mode, the controller can send signals to disable the recirculation pump 110 and can adjust a speed of the fan 108, as necessary, to maintain the process fluid set point or target. During such a switch, bypass dampers can be used to divert the airstream to bypass the pre-cooling coil 142 to reduce unnecessary air-side pressure drop and therefore save fan motor power. As shown within the controller 104, the controller 104 can perform a step 136 to determine whether the SWTmin is less than the PCW set point to determine when the switch to dry mode should be made, as discussed above with respect to FIG. 1.

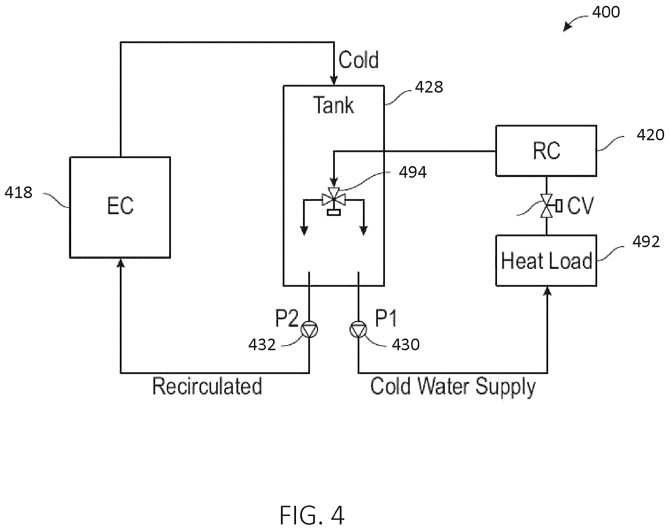

FIG. 4 illustrates a schematic view of an evaporative cooler system 400, in accordance with at least one example of this disclosure. In some examples, any of the components of the evaporative cooler system 400 can be included in any of the systems 100, 100A, and 100B discussed above. In some examples, instead of switching entirely between the distinct modes of operation for the adiabatic mode and evaporation mode, the system 400 can include a blended mode operation. Such a blended mode operation can include blending the adiabatic and evaporative modes together in differing ratios to control the mode transition and maintain optimal water efficiency. The transition between modes can involve significant changes in the operational state of the unit and can be difficult to control or avoid fluctuations in supply water temperature. The transition from the adiabatic mode to the evaporative mode can involve a sudden mixing of water or a sudden increase in cooling power as the evaporative coolers begin to receive warmer water and the evaporation rate increases significantly. This can result in the fan speed modulating from full speed (at the limit of the adiabatic mode) to a low speed in the evaporative mode to prevent over cooling. In examples where multiple cooling units are used, as the cooling load on the system 400 increases (when fewer conditioning units are selected for a given facility heat load), system 400 can spend minimal time in the adiabatic mode and switch to the evaporative mode where it can develop sufficient cooling capacity. The evaporative mode can be less efficient in terms of water usage, relative to the adiabatic mode, and water consumption can increase.

Operating in the blended mode can include monitoring and varying the ratio of the return process water from the cooling coil (RC) 420 into first and second sections of a water storage tank 428, and the first and second sections can be at least partially separated from one another. The blended mode operation can involve varying distribution of return process water from the cooling coil (RC) 420 into two pump suction bays of the tank 428 and corresponding pump suction inlets (for example of pumps 430 and 432 of FIG. 4) and consequently varying a mix ratio of warm and cold water into the pumped cold water supply (to the heat load 492) via the pump 430 and into the pumped recirculated water (to the evaporative cooler 418) via the pump 432. Valves (such as the 3-way valve 494) can control the proportion of hot return water going into the suction inlets of the pumps 430, 432, respectively (P-1, P-2). Though the system 400 shows a 3-way valve to control proportioning, two 2-way valves can be used in other examples to control the proportioning of hot return water going into the suction inlets of the pumps 430, 432, respectively (P-1, P-2).

The system 400 can be controlled to maintain a supply water temperature set point under varying ambient air conditions or varying cooling loads. The system 400 accomplishes this by varying the mix ratio of EC discharge water (into a back portion of the tank 428) and RC return water into the pump suction bays. For example, if the system 400 enters the wet mode of operation in the equivalent of the adiabatic mode (100% of RC return water into the first pump suction and 100% evaporative cooler discharge into the second pump suction) and the ambient outdoor air conditions rise (increased temperature or humidity), the supply water temperature delivered by the first pump 430 (P-1) may rise above the set point. In this case, a controller of the system 400 can begin to modulate the RC return valves (such as the 3-way valve 494) to divert a portion of the return water into the second pump suction bay, which can cause an equivalent portion of cold EC discharge water to flow into the first pump suction bay, lowering the supply water temperature to the set point. The mix ratio can be continuously modulated by the controller to maintain supply water temperature set point in response to varying ambient conditions and load. At peak ambient conditions or peak cooling loads the system may operate in the equivalent of the evaporative mode (100% of RC return water into P-2 suction, and P-1 suction being supplied essentially all by EC discharge water).

Such a blended wet mode can be interrupted when the controller (such as the controller 104 of FIGS. 1-3) determines that the SWTmin is less than the PCW set point of the system 400 when operating in the blended mode. In some examples, the controller 104 can make this determination by comparing the SWTmin to the PCW set point at each possible operating point of the blended mode at any given ambient temperature of the system 400.

Examples according to the present application can include a method of operating the system 400 in a blended mode at particular operating conditions between the adiabatic mode and the evaporative mode, where operating the conditioning system in the blended mode comprises distributing a first cooling fluid exiting the recovery coil between the first and second portions of the tank in a ratio such that a mix of the first and second cooling fluids in the supply water delivered to the heat load is at a temperature at or near a set point temperature for the conditioning system. Operating in the blended mode can include continuously monitoring and varying a ratio of the first cooling fluid distributed to the first and second portions of the tank to maintain the temperature of the supply water at or near the set point temperature.

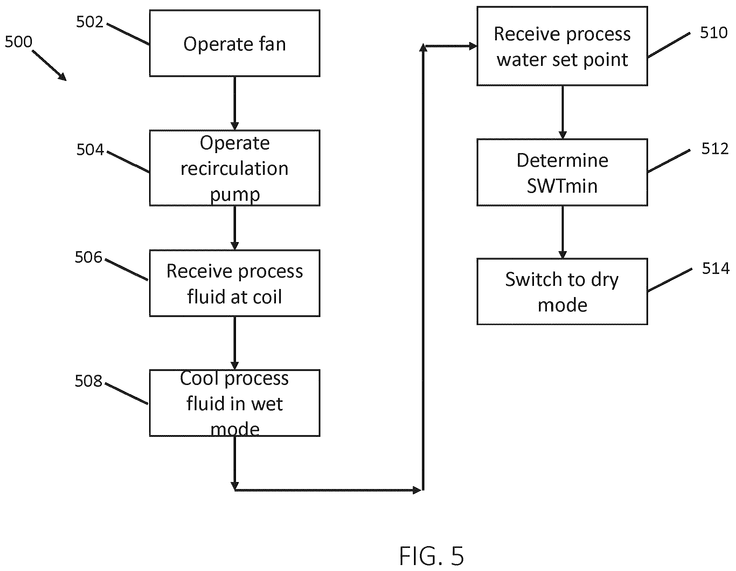

FIG. 5 illustrates a schematic view of a method 500, in accordance with at least one example of this disclosure. The steps or operations of the method 500 are illustrated in a particular order for convenience and clarity; many of the discussed operations can be performed in a different sequence or in parallel without materially impacting other operations. The method 500 as discussed includes operations performed by multiple different actors, devices, and/or systems. It is understood that subsets of the operations discussed in the method 500 can be attributable to a single actor, device, or system could be considered a separate standalone process or method.

The method 500 can begin at step 502, where the fan can be operated to deliver an airstream. For example, the fan 108 can be operated by the controller 104 to deliver the inlet air stream 130. At step 504, the recirculation pump can be operated to provide a working fluid. For example, the recirculation pump 110 can be operated by the controller 104 to provide the working fluid 134 to the cooling coil 106.

At step 506, the cooling coil can be located in the airstream and can receive a process fluid from a source. For example, the cooling coil 106 can be located in the airstream (130, 132) and can receive the process fluid 127 at the process fluid inlet 126 from the source 114. At step 508, the process fluid can be cooled in a wet mode by the evaporative cooler and by the cooling coil using the working fluid from the recirculation pump and the airstream. For example, the airstream 130 can be conditioned by the evaporative cooler 102 and the working fluid 134 from the recirculation pump 110. Then, while the system 100 is in a wet mode, the process fluid 127 is cooled by the cooling coil 106 using the conditioned air 131.

At step 510, a leaving process water temperature set point is received at a controller. For example, a leaving process water temperature set point can be received at the controller 104. At step 512, a minimum supply water temperature deliverable by the cooling coil in the dry mode is determined based on a coil performance model. For example, a minimum supply water temperature deliverable by the cooling coil 106 in the dry mode (SWTmin) can be determined based on a coil performance model by the controller 104. Then, at step 514, the system is switched from the wet mode to the dry mode when the leaving process water temperature set point is greater than the minimum supply water temperature. For example, the system 100 can be switched from the wet mode to the dry mode when the leaving process water temperature set point (PCW set point) is greater than the minimum supply water temperature (SWTmin).

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

## Claims

1. A hybrid evaporative cooler system (100) for cooling a process fluid (127), the hybrid evaporative cooler system (100) comprising:
a fan (108) configured to produce an airstream, the fan being located in or connected to an air tunnel or chamber;
an evaporative cooler (102) located upstream or downstream of the fan (108);
a cooling coil (106) located upstream or downstream of the fan (108), and located downstream of the evaporative cooler (102), and configured to receive the process fluid (127) from a source (114); and
a controller (104) configured to operate the hybrid evaporative cooler system (100) in a wet mode, in which the evaporative cooler (104) is activated to receive a working fluid (134) and to condition the airstream and in which the cooling coil (106) cools the process fluid (127) using the airstream, and configured to operate the evaporative cooler system (100) in a dry mode in which the evaporative cooler (102) is deactivated and in which the cooling coil (106) cools the process fluid (127) using the airstream, the controller (104) further configured to:
receive a temperature set point (510) for process fluid leaving the cooling coil (106);
determine a minimum fluid temperature based on a coil performance model (512), wherein the minimum fluid temperature is the lowest temperature of the process fluid (127) that the cooling coil (106) can deliver at a given ambient temperature or a given inlet air temperature while operating in the dry mode, and wherein the coil performance model (512) is configured to predict the minimum fluid temperature that can be achieved by the hybrid evaporative cooler system in dry mode for any given ambient temperature or any given inlet air temperature under any available operating condition; and
operate the hybrid evaporative cooler system in the dry mode on condition that the temperature set point is greater than the minimum fluid temperature (514).

2. The hybrid evaporative cooler system (100) of claim 1, further comprising:
a process fluid inlet temperature sensor (122) configured to transmit an inlet temperature signal to the controller (104) based on a process fluid inlet temperature;
wherein the minimum fluid temperature is determined based on the inlet temperature signal.

3. The hybrid evaporative cooler system (100) of claim 2, further comprising:
a process fluid outlet temperature sensor (124) configured to transmit an outlet temperature signal to the controller (104) based on a process fluid outlet temperature;
wherein the minimum fluid temperature is determined based on the inlet temperature signal and the outlet temperature signal.

4. The hybrid evaporative cooler system (100) of claim 3, further comprising:
a process fluid flow sensor (120) configured to transmit a flow signal to the controller (104) based on a process fluid flow rate;
wherein the minimum fluid temperature is determined based on the inlet temperature signal, the outlet temperature signal, and the flow signal.

5. The hybrid evaporative cooler system (100) of claim 4, further comprising:
a temperature sensor (116) configured to transmit an air temperature signal to the controller (104) based on an inlet air temperature;
wherein the minimum fluid temperature is determined based on the inlet temperature signal, the outlet temperature signal, the air temperature signal, and the flow signal.

6. The hybrid evaporative cooler system (100) of claim 2, further comprising:
a process fluid flow sensor (120) configured to transmit a flow signal to the controller (104) based on a process fluid flow rate;
wherein the minimum fluid temperature is determined based on the inlet temperature signal and the flow signal.

7. The hybrid evaporative cooler system (100) of any of claims 1 to 6,
wherein the coil performance model is a theoretical model, the theoretical model being a computational model that uses heat transfer and fluid mechanics equations to determine performance of the cooling coil (106) at the given operating condition.

8. The hybrid evaporative cooler system (100) of any of claims 1 to 6,
wherein the coil performance model is an empirical model, the empirical model being based on measurements taken in a lab and/or during operation of the cooling coil (106) or a similar cooling coil of another system.

9. The hybrid evaporative cooler system (100) of any of claims 1 to 8,
wherein the controller (104) is configured to update the coil performance model based on performance data collected over time to account for degradation in performance of the cooling coil (106).

10. A method of controlling a hybrid evaporative cooler system (100) to cool a process fluid (127), the method comprising:
cooling the process fluid using a cooling coil (106) located in an airstream produced by a fan (108), the fan being located in or connected to an air tunnel or chamber, the cooling coil (106) located upstream or downstream of the fan and located downstream of an evaporative cooler (102), the evaporative cooler (102) operable together with the cooling coil in a wet mode;
receiving a temperature set point (510) for process fluid leaving the cooling coil (106);
determining a minimum fluid temperature based on a coil performance model (512), wherein the minimum fluid temperature is the lowest temperature of the process fluid (127) that the cooling coil (106) can deliver at a given ambient temperature or at a given inlet air temperature while operating in a dry mode in which the evaporative cooler (102) is deactivated, and wherein the coil performance model (512) is configured to predict the minimum fluid temperature that can be achieved by the hybrid evaporative cooler system in dry mode for any given ambient temperature or any given inlet air temperature under any available operating condition; and
operating the hybrid evaporative cooler system (100) in the dry mode when the temperature set point is greater than the minimum fluid temperature.

11. The method of claim 10, further comprising:
receiving an inlet temperature signal produced by a fluid inlet temperature sensor (122) based on a process fluid inlet temperature;
wherein determining the minimum fluid temperature deliverable by the cooling coil (106) in the dry mode is based on the inlet temperature signal.

12. The method of claim 11, further comprising:
receiving an outlet temperature signal produced by a fluid outlet temperature sensor (124) based on a process fluid outlet temperature;
wherein determining the minimum fluid temperature deliverable by the cooling coil (106) in the dry mode is based on the inlet temperature signal and the outlet temperature signal.

13. The method of claim 12, further comprising:
receiving a flow signal produced by a process fluid flow sensor (120) based on a process fluid flow rate;
receiving an air temperature signal produced by a temperature sensor (116) based on an inlet air temperature;
wherein determining the minimum fluid temperature deliverable by the cooling coil (106) in the dry mode is based on the inlet temperature signal, the outlet temperature signal, the air temperature signal, and the flow signal.

## Patentansprüche

1. Hybride Verdunstungskühleranlage (100) zum Kühlen eines Prozessfluids (127), wobei die hybride Verdunstungskühleranlage (100) Folgendes umfasst:
ein Gebläse (108), das dafür konfiguriert ist, einen Luftstrom zu erzeugen, wobei das Gebläse in einem Lufttunnel oder einer -kammer angeordnet oder damit verbunden ist,
einen Verdunstungskühler (102), der stromaufwärts oder stromabwärts von dem Gebläse (108) angeordnet ist,
eine Kühlschlange (106), die stromaufwärts oder stromabwärts von dem Gebläse (108) angeordnet ist und stromabwärts von dem Verdunstungskühler (102) angeordnet ist und dafür konfiguriert ist, das Prozessfluid (127) von einer Quelle (114) zu empfangen, und
eine Steuerung (104), die dafür konfiguriert ist, die hybride Verdunstungskühleranlage (100) in einem nassen Moduls zu betreiben, in dem der Verdunstungskühler (104) aktiviert ist, um ein Arbeitsfluid (134) aufzunehmen und um den Luftstrom aufzubereiten, und in dem die Kühlschlange (106) das Prozessfluid (127) unter Verwendung des Luftstroms kühlt, und dafür konfiguriert ist, die Verdunstungskühleranlage (100) in einem trockenen Modus zu betreiben, in dem der Verdunstungskühler (102) deaktiviert ist und in dem die Kühlschlange (106) das Prozessfluid (127) unter Verwendung des Luftstroms kühlt, wobei die Steuerung (104) ferner zu Folgendem konfiguriert ist:
einen Temperatursollwert (510) für Prozessfluid, das die Kühlschlange (106) verlässt, zu empfangen,
eine minimale Fluidtemperatur auf Grundlage eines Schlangenleistungsmodells (512) zu bestimmen, wobei die minimale Fluidtemperatur die niedrigste Temperatur des Prozessfluids (127) ist, welche die Kühlschlange (106) bei einer gegebenen Umgebungstemperatur oder einer gegebenen Einlass-Lufttemperatur während des Betreibens im trockenen Modus liefern kann, und wobei das Schlangenleistungsmodell (512) dafür konfiguriert ist, die minimale Fluidtemperatur vorherzusagen, die durch die hybride Verdunstungskühleranlage im trockenen Modus für eine beliebige gegebene Umgebungstemperatur oder eine beliebige gegebene Einlass-Lufttemperatur unter einer beliebigen verfügbaren Betriebsbedingung erreicht werden kann, und
die hybride Verdunstungskühleranlage unter der Bedingung, dass der Temperatursollwert größer ist als die minimale Fluidtemperatur (514), in dem trockenen Modus zu betreiben.

2. Hybride Verdunstungskühleranlage (100) nach Anspruch 1, die ferner Folgendes umfasst:
einen Prozessfluid-Einlasstemperatursensor (122), der dafür konfiguriert ist, auf Grundlage einer Prozessfluid-Einlasstemperatur ein Einlasstemperatursignal an die Steuerung (104) zu übermitteln,
wobei die minimale Fluidtemperatur auf Grundlage des Einlasstemperatursignals bestimmt wird.

3. Hybride Verdunstungskühleranlage (100) nach Anspruch 2, die ferner Folgendes umfasst:
einen Prozessfluid-Auslasstemperatursensor (124), der dafür konfiguriert ist, auf Grundlage einer Prozessfluid-Auslasstemperatur ein Auslasstemperatursignal an die Steuerung (104) zu übermitteln,
wobei die minimale Fluidtemperatur auf Grundlage des Einlasstemperatursignals und des Auslasstemperatursignals bestimmt wird.

4. Hybride Verdunstungskühleranlage (100) nach Anspruch 3, die ferner Folgendes umfasst:
einen Prozessfluid-Durchflusssensor (120), der dafür konfiguriert ist, auf Grundlage einer Prozessfluid-Durchflussmenge ein Durchflusssignal an die Steuerung (104) zu übermitteln,
wobei die minimale Fluidtemperatur auf Grundlage des Einlasstemperatursignals, des Auslasstemperatursignals und des Durchflusssignals bestimmt wird.

5. Hybride Verdunstungskühleranlage (100) nach Anspruch 4, die ferner Folgendes umfasst:
einen Temperatursensor (116), der dafür konfiguriert ist, auf Grundlage einer Einlass-Lufttemperatur ein Lufttemperatursignal an die Steuerung (104) zu übermitteln,
wobei die minimale Fluidtemperatur auf Grundlage des Einlasstemperatursignals, des Auslasstemperatursignals, des Lufttemperatursignals und des Durchflusssignals bestimmt wird.

6. Hybride Verdunstungskühleranlage (100) nach Anspruch 2, die ferner Folgendes umfasst:
einen Prozessfluid-Durchflusssensor (120), der dafür konfiguriert ist, auf Grundlage einer Prozessfluid-Durchflussmenge ein Durchflusssignal an die Steuerung (104) zu übermitteln,
wobei die minimale Fluidtemperatur auf Grundlage des Einlasstemperatursignals und des Durchflusssignals bestimmt wird.

7. Hybride Verdunstungskühleranlage (100) nach einem der Ansprüche 1 bis 6, wobei das Schlangenleistungsmodell ein theoretisches Modell ist, wobei das theoretische Modell ein Rechenmodell ist, das Wärmeübertragungs- und Fluidmechanikgleichungen verwendet, um die Leistung der Kühlschlange (106) bei der gegebenen Betriebsbedingung zu bestimmen.

8. Hybride Verdunstungskühleranlage (100) nach einem der Ansprüche 1 bis 6, wobei das Schlangenleistungsmodell ein empirisches Modell ist, wobei das empirische Modell auf in einem Labor und/oder während des Betriebs der Kühlschlange (106) oder einer ähnlichen Kühlschlange einer anderen Anlage vorgenommenen Messungen beruht.

9. Hybride Verdunstungskühleranlage (100) nach einem der Ansprüche 1 bis 8, wobei die Steuerung (104) dafür konfiguriert ist, das Schlangenleistungsmodell auf Grundlage von über die Zeit gesammelten Leistungsdaten zu aktualisieren, um einen Abbau bei der Leistung der Kühlschlange (106) zu berücksichtigen.

10. Verfahren zum Steuern einer hybriden Verdunstungskühleranlage (100), um ein Prozessfluid (127) zu kühlen, wobei das Verfahren Folgendes umfasst:
Kühlen des Prozessfluids unter Verwendung einer Kühlschlange (106), die in einem Luftstrom angeordnet ist, der durch ein Gebläse (108) erzeugt wird, wobei das Gebläse in einem Lufttunnel oder eine -kammer angeordnet oder damit verbunden ist, wobei die Kühlschlange (106) stromaufwärts oder stromabwärts von dem Gebläse angeordnet ist und stromabwärts von dem Verdunstungskühler (102) angeordnet ist, wobei der Verdunstungskühler (102) zusammen mit der Kühlschlange in einem nassen Modus betreibbar ist,
Empfangen eines Temperatursollwerts (510) für Prozessfluid, das die Kühlschlange (106) verlässt,
Bestimmen einer minimalen Fluidtemperatur auf Grundlage eines Schlangenleistungsmodells (512), wobei die minimale Fluidtemperatur die niedrigste Temperatur des Prozessfluids (127) ist, welche die Kühlschlange (106) bei einer gegebenen Umgebungstemperatur oder bei einer gegebenen Einlass-Lufttemperatur während des Betreibens in einem trockenen Modus, in dem der Verdunstungskühler (102) deaktiviert ist, liefern kann, und wobei das Schlangenleistungsmodell (512) dafür konfiguriert ist, die minimale Fluidtemperatur vorherzusagen, die durch die hybride Verdunstungskühleranlage im trockenen Modus für eine beliebige gegebene Umgebungstemperatur oder eine beliebige gegebene Einlass-Lufttemperatur unter einer beliebigen verfügbaren Betriebsbedingung erreicht werden kann, und
Betreiben der hybriden Verdunstungskühleranlage (100) in dem trockenen Modus, wenn der Temperatursollwert größer ist als die minimale Fluidtemperatur.

11. Verfahren nach Anspruch 10, das ferner Folgendes umfasst:
Empfangen eines Einlasstemperatursignals, das durch einen Fluid-Einlasstemperatursensor (122) auf Grundlage einer Prozessfluid-Einlasstemperatur erzeugt wird,
wobei das Bestimmen der minimalen Fluidtemperatur, die durch die Kühlschlange (106) im trockenen Modus lieferbar ist, auf dem Einlasstemperatursignal beruht.

12. Verfahren nach Anspruch 11, das ferner Folgendes umfasst:
Empfangen eines Auslasstemperatursignals, das durch einen Fluid-Auslasstemperatursensor (124) auf Grundlage einer Prozessfluid-Auslasstemperatur erzeugt wird,
wobei das Bestimmen der minimalen Fluidtemperatur, die durch die Kühlschlange (106) im trockenen Modus lieferbar ist, auf dem Einlasstemperatursignal und dem Auslasstemperatursignal beruht.

13. Verfahren nach Anspruch 12, das ferner Folgendes umfasst:
Empfangen eines Durchflusssignals, das durch einen Prozessfluid-Durchflusssensor (120) auf Grundlage einer Prozessfluid-Durchflussmenge erzeugt wird,
Empfangen eines Lufttemperatursignals, das durch einen Temperatursensor (116) auf Grundlage einer Einlass-Lufttemperatur erzeugt wird,
wobei das Bestimmen der minimalen Fluidtemperatur, die durch die Kühlschlange (106) im trockenen Modus lieferbar ist, auf dem Einlasstemperatursignal, dem Auslasstemperatursignal, dem Lufttemperatursignal und dem Durchflusssignal beruht.

## Revendications

1. Système de refroidisseur à évaporation hybride (100) pour refroidir un fluide de processus (127), le système de refroidisseur à évaporation hybride (100) comprenant :
un ventilateur (108) configuré pour produire un flux d'air, le ventilateur étant localisé dans un tunnel ou une chambre à air ou lui étant connecté ;
un refroidisseur à évaporation (102) localisé en amont ou en aval du ventilateur (108) ;
une bobine de refroidissement (106) localisée en amont ou en aval du ventilateur (108), et localisée en aval du refroidisseur à évaporation (102), et configurée pour recevoir le fluide de processus (127) en provenance d'une source (114) ; et
un dispositif de commande (104) configuré pour faire fonctionner le système de refroidisseur à évaporation hybride (100) dans un mode humide dans lequel le refroidisseur à évaporation (104) est activé pour recevoir un fluide de travail (134) et pour conditionner le flux d'air et dans lequel la bobine de refroidissement (106) refroidit le fluide de processus (127) en utilisant le flux d'air, et configuré pour faire fonctionner le système de refroidisseur à évaporation (100) dans un mode sec dans lequel le refroidisseur à évaporation (102) est désactivé et dans lequel la bobine de refroidissement (106) refroidit le fluide de processus (127) en utilisant le flux d'air, le dispositif de commande (104) étant en outre configuré pour :
recevoir un point de consigne de température (510) pour le fluide de traitement qui quitte la bobine de refroidissement (106) ;
déterminer une température de fluide minimum sur la base d'un modèle de performance de bobine (512), dans lequel la température de fluide minimum est la température la plus basse du fluide de processus (127) que la bobine de refroidissement (106) peut délivrer à une température ambiante donnée ou à une température d'air d'entrée donnée pendant son fonctionnement dans le mode sec, et dans lequel le modèle de performance de bobine (512) est configuré pour prédire la température de fluide minimum qui peut être atteinte par le système de refroidisseur à évaporation hybride dans le mode sec pour une quelconque température ambiante donnée ou une quelconque température d'air d'entrée donnée sous n'importe quelle condition de fonctionnement disponible ; et
faire fonctionner le système de refroidisseur à évaporation hybride dans le mode sec moyennant la condition consistant en ce que le point de consigne de température est plus élevé que la température de fluide minimum (514).

2. Système de refroidisseur à évaporation hybride (100) selon la revendication 1, comprenant en outre :
un capteur de température d'entrée de fluide de processus (122) configuré pour transmettre un signal de température d'entrée au dispositif de commande (104) sur la base d'une température d'entrée de fluide de processus ;
dans lequel la température de fluide minimum est déterminée sur la base du signal de température d'entrée.

3. Système de refroidisseur à évaporation hybride (100) selon la revendication 2, comprenant en outre :
un capteur de température de sortie de fluide de processus (124) configuré pour transmettre un signal de température de sortie au dispositif de commande (104) sur la base d'une température de sortie de fluide de processus ;
dans lequel la température de fluide minimum est déterminée sur la base du signal de température d'entrée et du signal de température de sortie.

4. Système de refroidisseur à évaporation hybride (100) selon la revendication 3, comprenant en outre :
un capteur d'écoulement de fluide de processus (120) configuré pour transmettre un signal d'écoulement au dispositif de commande (104) sur la base d'un débit d'écoulement de fluide de processus ;
dans lequel la température de fluide minimum est déterminée sur la base du signal de température d'entrée, du signal de température de sortie et du signal d'écoulement.

5. Système de refroidisseur à évaporation hybride (100) selon la revendication 4, comprenant en outre :
un capteur de température (116) configuré pour transmettre un signal de température d'air au dispositif de commande (104) sur la base d'une température d'air d'entrée ;
dans lequel la température de fluide minimum est déterminée sur la base du signal de température d'entrée, du signal de température de sortie, du signal de température d'air et du signal d'écoulement.

6. Système de refroidisseur à évaporation hybride (100) selon la revendication 2, comprenant en outre :
un capteur d'écoulement de fluide de processus (120) configuré pour transmettre un signal d'écoulement au dispositif de commande (104) sur la base d'un débit d'écoulement de fluide de processus ;
dans lequel la température de fluide minimum est déterminée sur la base du signal de température d'entrée et du signal d'écoulement.

7. Système de refroidisseur à évaporation hybride (100) selon l'une quelconque des revendications 1 à 6, dans lequel le modèle de performance de bobine est un modèle théorique, le modèle théorique étant un modèle de calcul qui utilise des équations de transfert thermique et de la mécanique des fluides pour déterminer la performance de la bobine de refroidissement (106) à la condition de fonctionnement donnée.

8. Système de refroidisseur à évaporation hybride (100) selon l'une quelconque des revendications 1 à 6, dans lequel le modèle de performance de bobine est un modèle empirique, le modèle empirique étant basé sur des mesures prises en laboratoire et/ou pendant le fonctionnement de la bobine de refroidissement (106) ou d'une bobine de refroidissement similaire d'un autre système.

9. Système de refroidisseur à évaporation hybride (100) selon l'une quelconque des revendications 1 à 8, dans lequel le dispositif de commande (104) est configuré pour mettre à jour le modèle de performance de bobine sur la base de données de performance collectées au fil du temps pour prendre en compte la dégradation de la performance de la bobine de refroidissement (106).

10. Procédé de commande d'un système de refroidisseur à évaporation hybride (100) pour refroidir un fluide de processus (127), le procédé comprenant :
le refroidissement du fluide de processus en utilisant une bobine de refroidissement (106) localisée dans un flux d'air produit par un ventilateur (108), le ventilateur étant localisé dans un tunnel ou une chambre à air ou lui étant connecté, la bobine de refroidissement (106) étant localisée en amont ou en aval du ventilateur et étant localisée en aval du refroidisseur à évaporation (102), le refroidisseur à évaporation (102) pouvant fonctionner en association avec la bobine de refroidissement dans un mode humide ;
la réception d'un point de consigne de température (510) pour le fluide de processus qui quitte la bobine de refroidissement (106) ;
la détermination d'une température de fluide minimum sur la base d'un modèle de performance de bobine (512), dans lequel la température de fluide minimum est la température la plus basse du fluide de processus (127) que la bobine de refroidissement (106) peut délivrer à une température ambiante donnée ou à une température d'air d'entrée donnée pendant son fonctionnement dans un mode sec dans lequel le refroidisseur à évaporation (102) est désactivé, et dans lequel le modèle de performance de bobine (512) est configuré pour prédire la température de fluide minimum qui peut être atteinte par le système de refroidisseur à évaporation hybride dans le mode sec pour une quelconque température ambiante donnée ou une quelconque température d'air d'entrée donnée sous n'importe quelle condition de fonctionnement disponible ; et
le fait de faire fonctionner le système de refroidisseur à évaporation hybride (100) dans le mode sec lorsque le point de consigne de température est plus élevé que la température de fluide minimum.

11. Procédé selon la revendication 10, comprenant en outre :
la réception d'un signal de température d'entrée produit par un capteur de température d'entrée de fluide (122) sur la base d'une température d'entrée de fluide de processus ;
dans lequel la détermination de la température de fluide minimum qui peut être délivrée par la bobine de refroidissement (106) dans le mode sec est basée sur le signal de température d'entrée.

12. Procédé selon la revendication 11, comprenant en outre :
la réception d'un signal de température de sortie produit par un capteur de température de sortie de fluide (124) sur la base d'une température de sortie de fluide de processus ;
dans lequel la détermination de la température de fluide minimum qui peut être délivrée par la bobine de refroidissement (106) dans le mode sec est basée sur le signal de température d'entrée et le signal de température de sortie.

13. Procédé selon la revendication 12, comprenant en outre :
la réception d'un signal d'écoulement produit par un capteur d'écoulement de fluide de processus (120) sur la base d'un débit d'écoulement de fluide de processus ; et
la réception d'un signal de température d'air produit par un capteur de température (116) sur la base d'une température d'air d'entrée ;
dans lequel la détermination de la température de fluide minimum qui peut être délivrée par la bobine de refroidissement (106) dans le mode sec est basée sur le signal de température d'entrée, le signal de température de sortie, le signal de température d'air et le signal d'écoulement.
